# EUROPEAN PATENT APPLICATION

(11) **EP 4 535 653 A1**
(43) Date of publication of application: **09.04.2025**
(21) Application number: 22944705.7
(22) Date of filing: 27.12.2022
(51) Int. Cl.: H02S 50/00, G01R 31/12

(54) **PHOTOVOLTAIC SYSTEM DIRECT-CURRENT ARC FAULT DETECTION METHOD, APPARATUS AND DEVICE, AND MEDIUM**

(30) Priority: 01.06.2022 CN 202210611389
(71) Applicant: Sungrow Power Supply Co., Ltd., Hefei, Anhui 230088 (CN)
(72) Inventor: ZHANG, Ran, Hefei, Anhui 230088 (CN); HUANG, Zhifeng, Hefei, Anhui 230088 (CN); LI, Haitao, Hefei, Anhui 230088 (CN); HE, Yi, Hefei, Anhui 230088 (CN); PAN, Nian'an, Hefei, Anhui 230088 (CN); YU, Yanfei, Hefei, Anhui 230088 (CN)
(74) Representative: Zacco Norway AS
(86) International application number: PCT/CN2022/142444
(87) International publication number: WO 2023/231404

(57) **Abstract**

Disclosed in the present invention are a photovoltaic system direct-current arc fault detection method, apparatus and device, and a computer readable storage medium. The method comprises: detecting whether an optimizer control apparatus and a power optimizer in a photovoltaic system are in a communication state; if it is determined that the optimizer control apparatus and the power optimizer are not in the communication state, acquiring a direct-current side alternating-current signal of an inverter in the photovoltaic system; extracting a signal feature of a preset arc detection frequency band in the direct-current side alternating-current signal as a first arc signal feature; and analyzing according to the first arc signal feature to obtain a direct-current arc fault detection result of the photovoltaic system. According to the present invention, direct-current arc fault detection is performed by using gaps in power optimizer communication; thus, the impact of power optimizer communication on arc detection is avoided while functions of the power optimizer and the arc detection are compatible, and the false detection rate of arc detection is reduced.

## Description

This application claims the priority to Chinese Patent Application No. 202210611389.8, titled "PHOTOVOLTAIC SYSTEM DIRECT-CURRENT ARC FAULT DETECTION METHOD, APPARATUS AND DEVICE, AND MEDIUM", filed on June 1, 2022 with the China National Intellectual Property Administration, which is incorporated herein by reference in its entirety.

### FIELD

The present disclosure relates to the technical field of photovoltaic power stations, and in particular to a method, an apparatus and a device for direct-current arc fault detection in a photovoltaic system, and a computer-readable storage medium.

### BACKGROUND

Arc is a gas discharge phenomenon. In a photovoltaic system, once an arc fault occurs, if no effective protection measure is taken, the high temperature generated by the continuous direct-current arc easily causes a fire and a major safety accident. In the existing arc detection technology, whether a direct-current arc fault occurs is detected by extracting a signal at a direct-current side to detect and identify a frequency domain feature of the arc. A power optimizer is arranged in the photovoltaic system, to regulate the power output of each photovoltaic panel and improve the power generation efficiency of the photovoltaic string, in order to solve the power mismatch problem caused by partial shading of photovoltaic modules and component aging. An optimizer control device performs information interaction with the power optimizer at each secondary node through PLC (Power Line Communication).

A high-frequency harmonic signal is coupled into communication of the power optimizer through cables, and the frequency domain feature for arc detection is mainly extracted from the harmonic signal coupled by cables, and thus the communication of the power optimizer inevitably have an impact on the arc detection, resulting in an error of the arc detection.

### SUMMARY

The main purpose of the present disclosure lies in providing a method, an apparatus and a device for direct-current arc fault detection in a photovoltaic system, and a computer-readable storage medium, to solve the problem of an error of the arc detection caused by the communication of the power optimizer, while the photovoltaic system is provided with the power optimizer and has an arc detection function.

In order to achieve the aforementioned objectives, a method for direct-current arc fault detection in a photovoltaic system is provided according to the present disclosure, and the method includes: detecting whether an optimizer control device is in communication with a power optimizer in the photovoltaic system; acquiring an alternating-current signal at a direct-current side of an inverter in the photovoltaic system, if it is determined that the optimizer control device is not in communication with the power optimizer; extracting a signal feature of the alternating-current signal at the direct-current side in a preset arc detection frequency band as a first arc signal feature; and analyzing the first arc signal feature to obtain a result of the direct-current arc fault detection in the photovoltaic system.

In an embodiment, the method for direct-current arc fault detection in a photovoltaic system further includes: cyclically triggering a communication between the optimizer control device and the power optimizer at a first preset time interval, where the communication is terminated if an end of information interaction is detected by the optimizer control device or the power optimizer.

In an embodiment, a quantity of the power optimizer in the photovoltaic system is more than one, and the power optimizer is configured for power optimization on at least one photovoltaic module in the photovoltaic system. After the analyzing the first arc signal feature to obtain a result of the direct-current arc fault detection in the photovoltaic system, the method further includes: obtaining a module voltage of the at least one photovoltaic module from each of the plurality of power optimizers, if the result of the direct-current arc fault detection is that a direct-current arc fault occurs in the photovoltaic system; obtaining a voltage anomaly detection threshold; and determining that the direct-current arc fault occurs in the at least one photovoltaic module, if the module voltage of the at least one photovoltaic module is less than the voltage anomaly detection threshold.

In an embodiment, the obtaining a voltage anomaly detection threshold includes: calculating a mean value of the module voltages of all the photovoltaic modules, and multiplying the mean value by a first preset multiple to obtain the voltage anomaly detection threshold, where the first preset multiple is greater than 0 and less than 1.

In an embodiment, the obtaining an voltage anomaly detection threshold includes: determining a historical module voltage of each of the at least one photovoltaic module, obtained from the power optimizer corresponding to the at least one photovoltaic module during a period that no direct-current arc fault occurs in the photovoltaic system, as the voltage anomaly detection threshold corresponding to the photovoltaic module. The determining that the direct-current arc fault occurs in the at least one photovoltaic module if the module voltage of the at least one photovoltaic module is less than the voltage anomaly detection threshold includes determining that the direct-current arc fault occurs in the photovoltaic module, if the module voltage of the photovoltaic module is less than the voltage anomaly detection threshold corresponding to the photovoltaic module.

In an embodiment, the extracting a signal feature of the alternating-current signal at the direct-current side in a preset arc detection frequency band as a first arc signal feature includes: converting the alternating-current signal at the direct-current side from a time domain to a frequency domain to obtain a frequency domain signal; and performing feature extraction on signals in the preset arc detection frequency band in the frequency domain signal to obtain the first arc signal feature, where the feature extraction at least includes calculating one or more of a mean value, a root mean square value, a variance and a kurtosis of the signals in the preset arc detection frequency band.

In an embodiment, the analyzing the first arc signal feature to obtain a result of the direct-current arc fault detection in the photovoltaic system includes: obtaining an arc fault determination threshold, wherein the arc fault determination threshold is a preset fixed threshold or an adaptive threshold calculated based on second arc signal features in a historical data set; and comparing the first arc signal feature with the arc fault determination threshold, and obtaining the result of the direct-current arc fault detection in the photovoltaic system based on a comparison result.

In an embodiment, the arc fault determination threshold is the adaptive threshold calculated based on the second arc signal features in the historical data set, and the obtaining the arc fault determination threshold includes: obtaining the preset historical data set, calculating a mean value of the second arc signal features in the historical data set, and multiplying the mean value by a second preset multiple to obtain the arc fault determination threshold.

In an embodiment, after the analyzing the first arc signal feature to obtain a result of the direct-current arc fault detection in the photovoltaic system, the method further includes: shutting down the inverter to report an arc fault if the result of the direct-current arc fault detection is that the direct-current arc fault occurs in the photovoltaic system; starting the inverter if a preset self-starting condition is met and a duration for which the inverter is shut down is a second preset duration; and going to the process of acquiring an alternating-current signal at a direct-current side of an inverter in the photovoltaic system.

In order to achieve the aforementioned objectives, an apparatus for direct-current arc fault detection in a photovoltaic system is provided according to the present disclosure, and the apparatus for direct-current arc fault detection in a photovoltaic system includes: a detection module, configured to detect whether an optimizer control device is in communication with a power optimizer in the photovoltaic system; an acquisition module, configured to acquire an alternating-current signal at a direct-current side of an inverter in the photovoltaic system, if it is determined that the optimizer control device is not in communication with the power optimizer; an extraction module, configured to extract a signal feature of the alternating-current signal at the direct-current side in a preset arc detection frequency band as a first arc signal feature; and an analysis module, configured to analyze the first arc signal feature to obtain a result of the direct-current arc fault detection in the photovoltaic system.

In order to achieve the aforementioned objectives, a device for direct-current arc fault detection in a photovoltaic system is provided according to the present disclosure. The device for direct-current arc fault detection in a photovoltaic system includes: a memory, a processor, and a program for direct-current arc fault detection in a photovoltaic system stored in the memory and executable by the processor, where the program for direct-current arc fault detection in a photovoltaic system performs, when being executed by the processor, the method for direct-current arc fault detection in a photovoltaic system described above.

In addition, in order to achieve the aforementioned objectives, a computer-readable storage medium is provided according to the present disclosure. The computer-readable storage medium stores a program for direct-current arc fault detection in a photovoltaic system, where the program for direct-current arc fault detection in a photovoltaic system performs, when being executed by a processor, the method for direct-current arc fault detection in a photovoltaic system described above.

In the present disclosure, whether an optimizer control device is in communication with a power optimizer in the photovoltaic system is detected; an alternating-current signal at the direct-current side of the inverter in the photovoltaic system is acquired, if it is determined that the optimizer control device is not in communication with the power optimizer; a signal feature of the alternating-current signal at the direct-current side in a preset arc detection frequency band is extracted as a first arc signal feature; and the first arc signal feature is analyzed to obtain a result of the direct-current arc fault detection in the photovoltaic system. In the present disclosure, the direct-current arc fault detection is performed during the time interval of the communications of the power optimizer, avoiding the impact of communication of the power optimizer on the arc detection and reducing the false detection rate, while the photovoltaic system is provided with the power optimizer and has an arc detection function.

### BRIEF DESCRIPTION OF THE DRAWINGS

FIG. 1 is a schematic structural diagram illustrating an operating environment in hardware involved in solutions according to an embodiment of the present disclosure;
FIG. 2 is a schematic flowchart of a method for direct-current arc fault detection in a photovoltaic system according to an embodiment of the present disclosure;
FIG. 3 is a schematic diagram illustrating an architecture of a photovoltaic system according to an embodiment of the present disclosure;
FIG. 4 is a schematic flowchart of a process of direct-current arc fault detection according to an embodiment of the present disclosure; and
FIG. 5 is a schematic diagram illustrating a functional module of an apparatus for direct-current arc fault detection in a photovoltaic system according to an embodiment of the present disclosure.

### DETAILED DESCRIPTION

It should be understood that the embodiments described herein are merely for explaining rather than limiting the present disclosure.

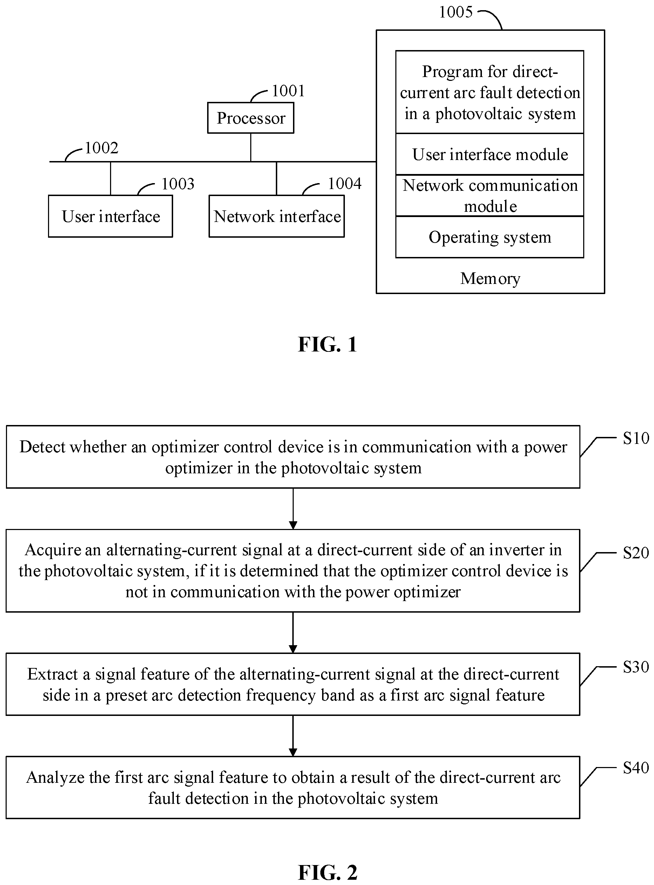

Reference is made to FIG. 1, which is a schematic structural diagram illustrating a device with operating environment in hardware involved in solutions according to an embodiment of the present disclosure.

It should be noted that, a device for direct-current arc fault detection in a photovoltaic system according to the embodiment of the present disclosure may be a smart phone, a personal computer, a server or the like, which is not limited herein.

As shown in FIG. 1, the device for direct-current arc fault detection in a photovoltaic system may include: a processor 1001, for example, a CPU, a network interface 1004, a user interface 1003, a memory 1005, and a communication bus 1002. Where, the communication bus 1002 is configured to implement connection and communication between the modules. The user interface 1003 may include a display, and an input unit such as a keyboard. The user interface 1003 may further include a standard wired interface or wireless interface. The network interface 1004 may include a standard wired interface or wireless interface (for example, a WI-FI interface). The memory 1005 may be a high-speed RAM memory, or a non-volatile memory such as a magnetic disk memory. Alternatively, the memory 1005 is a storage device independent of the processor 1001.

Those skilled in the art may understand that the device structure shown in FIG. 1 does not constitute a limitation to the device for direct-current arc fault detection in a photovoltaic system, and the device may include more components or fewer components than those shown in FIG. 1, some components may be combined, or the components may be deployed in different manners.

As shown in FIG. 1, the memory 1005, as a computer storage medium, may include an operating system, a network communication module, a user interface module, and a program for direct-current arc fault detection in a photovoltaic system. The operating system is a program that manages and controls hardware and software resources on a device and supports operation of the program for direct-current arc fault detection in a photovoltaic system and other software or program. In the device shown in FIG. 1, the user interface 1003 is configured to perform data communication with a client terminal. The network interface 1004 is configured to establish a communication connection with a server. The processor 1001 is configured to invoke the program for direct-current arc fault detection in a photovoltaic system stored in the memory 1005 to perform the following operations of: detecting whether an optimizer control device is in communication with a power optimizer in the photovoltaic system; acquiring an alternating-current signal at a direct-current side of an inverter in the photovoltaic system, if it is determined that the optimizer control device is not in communication with the power optimizer; extracting a signal feature of the alternating-current signal at the direct-current side in a preset arc detection frequency band as a first arc signal feature; and analyzing the first arc signal feature to obtain a result of the direct-current arc fault detection in the photovoltaic system.

Furthermore, the processor 1001 is further configured to invoke the program for direct-current arc fault detection in a photovoltaic system stored in the memory 1005 to perform the following operations of: cyclically triggering a communication between the optimizer control device and the power optimizer at a first preset time interval, where the communication is terminated if an end of information interaction is detected by the optimizer control device or the power optimizer.

Furthermore, a quantity of the power optimizer in the photovoltaic system is more than one, and the power optimizer is configured for power optimization on at least one photovoltaic module in the photovoltaic system.

After the operation of analyzing the first arc signal feature to obtain a result of the direct-current arc fault detection in the photovoltaic system, the processor 1001 is further configured to invoke the program for direct-current arc fault detection in a photovoltaic system stored in the memory 1005 to perform the following operations of: obtaining a module voltage of the at least one photovoltaic module from each of the multiple power optimizers, if the result of the direct-current arc fault detection is that a direct-current arc fault occurs in the photovoltaic system; obtaining a voltage anomaly detection threshold; and determining that the direct-current arc fault occurs in the at least one photovoltaic module, if the module voltage of the at least one photovoltaic module is less than the voltage anomaly detection threshold.

Furthermore, the operation of obtaining an voltage anomaly detection threshold includes: calculating a mean value of the module voltages of all the photovoltaic modules, and multiplying the mean value by a first preset multiple to obtain the voltage anomaly detection threshold, where the first preset multiple is greater than 0 and less than 1.

Furthermore, the operation of obtaining an voltage anomaly detection threshold includes: determining a historical module voltage of each of the at least one photovoltaic module, obtained from the power optimizer corresponding to the at least one photovoltaic module during a period that no direct-current arc fault occurs in the photovoltaic system, as the voltage anomaly detection threshold corresponding to the photovoltaic module, where the operation of determining that the direct-current arc fault occurs in the at least one photovoltaic module if the module voltage of the at least one photovoltaic module is less than the voltage anomaly detection threshold includes: determining that the direct-current arc fault occurs in the photovoltaic module if the module voltage of the photovoltaic module is less than the voltage anomaly detection threshold corresponding to the photovoltaic module.

Furthermore, the operation of extracting a signal feature of the alternating-current signal at the direct-current side in a preset arc detection frequency band as a first arc signal feature includes: converting the alternating-current signal at the direct-current side from a time domain to a frequency domain to obtain a frequency domain signal; and performing feature extraction on signals in the preset arc detection frequency band in the frequency domain signal to obtain the first arc signal feature, where the feature extraction at least includes calculating one or more of a mean value, a root mean square value, a variance and a kurtosis of the signals in the preset arc detection frequency band.

Furthermore, the operation of analyzing the first arc signal feature to obtain a result of the direct-current arc fault detection in the photovoltaic system includes: obtaining an arc fault determination threshold, where the arc fault determination threshold is a preset fixed threshold or an adaptive threshold calculated based on second arc signal features in a historical data set; and comparing the first arc signal feature with the arc fault determination threshold, and obtaining the result of the direct-current arc fault detection in the photovoltaic system based on a comparison result.

Furthermore, the arc fault determination threshold is the adaptive threshold calculated based on the second arc signal features in the historical data set, the operation of obtaining the arc fault determination threshold includes: obtaining the preset historical data set, calculating a mean value of the second arc signal features in the historical data set, and multiplying the mean value by a second preset multiple to obtain the arc fault determination threshold.

Furthermore, after the operation of analyzing the first arc signal feature to obtain a result of the direct-current arc fault detection in the photovoltaic system, the processor 1001 is further configured to invoke the program for direct-current arc fault detection in a photovoltaic system stored in the memory 1005 to perform the following operations of: shutting down the inverter to report an arc fault if the result of the direct-current arc fault detection is that the direct-current arc fault occurs in the photovoltaic system; starting the inverter if a preset self-starting condition is met and a duration for which the inverter is shut down is a second preset duration; and going to the operation of acquiring an alternating-current signal at a direct-current side of an inverter in the photovoltaic system.

Based on the aforementioned structure, a method for direct-current arc fault detection in a photovoltaic system is provided according to some embodiments.

Reference is made to FIG.2, which is a schematic flowchart of a method for direct-current arc fault detection in a photovoltaic system according to an embodiment of the present disclosure.

A method for direct-current arc fault detection in a photovoltaic system is provided according to the embodiment of the present disclosure. It should be noted that although steps are shown in a logic order in the flow chart, the shown or described steps may be performed in a different order in some cases. In this embodiment, an execution subject of the method for direct-current arc fault detection in the photovoltaic system is not limited. For the convenience of description, each embodiment is described below with an arc detection device as the execution subject. In the implementation, the arc detection device may be arranged inside an inverter of the photovoltaic system or outside the inverter, and is able to establish communication with the inverter. In this embodiment, the method for direct-current arc fault detection in the photovoltaic system includes the following steps S10 to S40.

In step S10, whether an optimizer control device is in communication with a power optimizer in the photovoltaic system is detected.

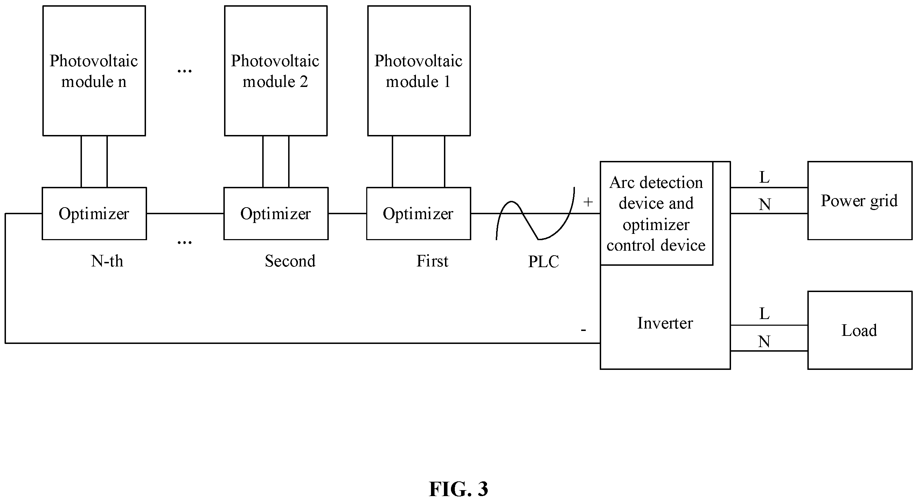

A direct-current side of the inverter in the photovoltaic system is connected to a photovoltaic string, and an alternating-current side of the inverter is connected to a power grid and a load. The inverter is configured to convert direct-current power outputted from the photovoltaic string into alternating-current power and output the alternating-current power to the power grid and/or load. The optimizer control device is configured to control the power optimizer, and is connected in series with the inverter or arranged inside the inverter (the following is an example where the optimizer control device is arranged inside the inverter). The power optimizer performs power optimization on at least one photovoltaic module, and the power optimizer and the photovoltaic module optimized by the power optimizer may be regarded as a whole (a manner in which the power optimizer is connected to the photovoltaic module is not limited in this embodiment). Various photovoltaic modules are connected in series through positive electrodes and negative electrodes of the power optimizers to form a photovoltaic string. A positive electrode and a negative electrode of the photovoltaic string are connected to a positive electrode and a negative electrode of the direct-current side of the inverter, respectively. In a case that the number of the photovoltaic string is more than one, each photovoltaic string is connected to the inverter, that is, the multiple photovoltaic strings are connected in parallel. During the operation of the photovoltaic system, the optimizer control device is in communication with the power optimizer regularly or irregularly. In this embodiment, a communication frequency between the optimizer control device and the power optimizer is not limited. FIG. 3 is a schematic diagram illustrating an architecture of the photovoltaic system, which is only exemplary and should not be understood to limit the architecture, function, and scope of use of the photovoltaic system in this embodiment.

The arc detection device may detect whether the optimizer control device is in communication with the power optimizer, and determine whether to perform direct-current arc fault detection based on a detection result. Where, whether the optimizer control device is in communication with the power optimizer may be detected in multiple manners, and the manners are not limited in this embodiment. For example, in an implementation, a communication flag may be set, the communication flag is set to 1 during the communication between the optimizer control device and the power optimizer, and the communication flag is set to 0 immediately after the optimizer control device is in communication with the power optimizer. It is determined whether the optimizer control device is currently in communication with the power optimizer by detecting the value of the communication flag. It should be understood that the communication flag of 0 indicates that the optimizer control device is in communication with the power optimizer, and the communication flag of 1 indicates that the optimizer control device is not in communication with the power optimizer.

In step S20, an alternating-current signal at the direct-current side of the inverter in the photovoltaic system is acquired, if it is determined that the optimizer control device is not in communication with the power optimizer.

Upon determining that the optimizer control device is not in communication with the power optimizer, the arc detection device may acquire the alternating-current signal at the direct-current side of the inverter. A current signal at the direct-current side is mixed with some alternating-current signals, and thus the current signal acquired at the direct-current side is referred to as the alternating-current signal at the direct-current side.

In step S30, a signal feature of the alternating-current signal at the direct-current side in a preset arc detection frequency band is extracted as a first arc signal feature.

After acquiring the alternating-current signal at the direct-current side, the arc detection device extracts the signal feature of the alternating-current signal at the direct-current side in the preset arc detection frequency band. Where, the preset arc detection frequency band is a preset frequency band, and this frequency band is considered to be the frequency band where the arc signal feature is. Hence, the extracted signal feature is referred to as the arc signal feature (hereinafter referred to as the first arc signal feature for distinction).

A method for extracting the first arc signal feature is not limited in this embodiment. In an embodiment, a method commonly used for extracting a frequency domain signal feature may be used.

In step S40, the first arc signal feature is analyzed to obtain a result of the direct-current arc fault detection in the photovoltaic system.

After extracting the first arc signal feature, the arc detection device may determine whether a direct-current arc fault occurs in the photovoltaic system based on the first arc signal feature, and the result of the direct-current arc fault detection may be obtained. The method for determining whether the direct-current arc fault occurs in the photovoltaic system based on the first arc signal feature is not limited in this embodiment. For example, it is determined whether the direct-current arc fault occurs in the photovoltaic system based on a comparison result of the first arc signal feature and a preset fixed threshold or an adaptive threshold.

It can be understood that since the first arc signal feature is extracted if it is detected that the optimizer control device is not in communication with the power optimizer, it is determined that the first arc signal feature is not affected by the communication between the optimizer control device and the power optimizer. Therefore, the result that the direct-current arc fault occurs in the photovoltaic system determined based on the first arc signal feature is relatively credible, that is, avoiding the impact of communication of the power optimizer on arc detection, and reducing the false detection rate of the arc detection.

Furthermore, in an embodiment, if the result of the direct-current arc fault detection is that the direct-current arc fault occurs in the photovoltaic system, the arc detection device may take a corresponding measure to avoid the impact of the direct-current arc fault. The measure to be taken is not limited in this embodiment. For example, an alarm device may be controlled to send an alarm.

Furthermore, in an embodiment, if the arc detection device determines that the optimizer control device is not in communication with the power optimizer, the arc detection device does not perform arc detection until the optimizer control device is not in communication with the power optimizer. It can be understood that a duration for which the power optimizer is in communication with the optimizer control device is generally very short. Although no arc detection is performed during the duration for which the power optimizer is in communication with the optimizer control device, a time interval of two communications is coming soon, and the direct-current arc fault can be detected during the time interval of two communications once the direct-current arc fault occurs, thereby avoiding the adverse effect caused by the direct-current arc fault.

Furthermore, in an embodiment, the method for direct-current arc fault detection in a photovoltaic system further includes the following step a.

In step a, a communication between the optimizer control device and the power optimizer is cyclically triggered at a first preset time interval, where the communication is terminated if an end of information interaction is detected by the optimizer control device or the power optimizer.

The arc detection device may cyclically trigger the communication between the optimizer control device and the power optimizer at the first preset time interval. Where, the first preset time interval may be set as needed, and a larger first preset time interval indicates a higher timeliness of arc detection. That is, the arc fault detection is performed during the time interval of two communications between the optimizer control device and the power optimizer. Since the duration for which the power optimizer is in communication with the optimizer control device once is very short, the larger first preset time interval indicates the longer time interval of two communications and the higher arc detection frequency, so that it can be detected that a direct-current arc fault occurs in the photovoltaic system in a real time manner. The optimizer control device or the power optimizer terminates the communication upon detecting that the information interaction ends, allowing the arc detection device to perform arc detection.

Furthermore, in an embodiment, the step S30 includes the following steps S301 and S302.

In step S301, the alternating-current signal at the direct-current side is converted from a time domain to a frequency domain to obtain a frequency domain signal.

In this embodiment, a method for extracting the first arc signal feature of the alternating-current signal at the direct-current side is provided. The arc detection device first converts the alternating-current signal at the direct-current side from the time domain to the frequency domain to obtain the frequency domain signal. It can be understood that the acquired alternating-current signal at the direct-current side is a signal including current at different time instants, which belongs to the time domain signal. In order to extract the signal feature in the preset arc detection frequency band, the alternating-current signal at the direct-current side is first converted from the time domain to the frequency domain, and the converted signal is referred to as the frequency domain signal. In this embodiment, the method for converting the signal from the time domain to the frequency domain is not limited. For example, the fast Fourier transform method may be adopted.

In step S302, feature extraction is performed on signals in the preset arc detection frequency band in the frequency domain signal to obtain the first arc signal feature, where the feature extraction at least includes calculating one or more of a mean value, a root mean square value, a variance and a kurtosis of the signals in the preset arc detection frequency band.

Upon obtaining the converted frequency domain signal, the signals in the preset arc detection frequency band may be extracted from the frequency domain signal, and feature extraction is performed on the signals to obtain the first arc signal feature. Depending on the actual needs, the feature extraction may at least include calculating one or more of the mean value, the root mean square value, the variance and the kurtosis of the signals in the preset arc detection frequency band, and the method of calculating the mean value, the root mean square value, the variance, and the kurtosis is not described in detail herein. It can be understood that in other implementations, feature extraction is performed in other manner.

In this embodiment, whether the optimizer control device is in communication with the power optimizer in the photovoltaic system is detected, the alternating-current signal at the direct-current side of the inverter in the photovoltaic system is acquired if it is determined that the optimizer control device is not in communication with the power optimizer, the signal feature of the alternating-current signal at the direct-current side in the preset arc detection frequency band is extracted as the first arc signal feature, and the first arc signal feature is analyzed to obtain a result of the direct-current arc fault detection in the photovoltaic system. In this embodiment, the direct-current arc fault detection is performed during the time interval of the communications of the power optimizer, avoiding the impact of communication of the power optimizer on the arc detection and reducing the false detection rate, while the photovoltaic system is provided with the power optimizer and has an arc detection function.

Furthermore, based on the aforementioned embodiment, the method for direct-current arc fault detection in the photovoltaic system is provided according to another embodiment. In this embodiment, a quantity of the power optimizer in the photovoltaic system is more than one, and the power optimizer is configured for power optimization on at least one photovoltaic module in the photovoltaic system. After step S40, the method for direct-current arc fault detection further includes the following steps S50 to S70.

In step S50, a module voltage of the photovoltaic module is obtained from each of the power optimizers, if the result of the direct-current arc fault detection is that the direct-current arc fault occurs in the photovoltaic system.

In this embodiment, the power optimizer is configured to obtain a voltage (hereinafter referred to as the module voltage) of the photovoltaic module optimized by the power optimizer, for locating a photovoltaic module where the direct-current arc fault occurs.

In an embodiment, the power optimizer may detect the module voltage of the optimized photovoltaic module, and send the module voltage of the optimized photovoltaic module to the optimizer control device by using the communication between the power optimizer and the optimizer control device, so that the arc detection device can acquire the module voltage of the photovoltaic module from the optimizer control device.

In step S60, a voltage anomaly detection threshold is obtained.

In step S70, it is determined that the direct-current arc fault occurs in the photovoltaic module, if the module voltage of the photovoltaic module is less than the voltage anomaly detection threshold.

Some cells of the photovoltaic module are damaged caused by the direct-current arc fault occurring in the photovoltaic module, and the module voltage of the photovoltaic module decreases accordingly. The voltage anomaly detection threshold is for determining whether the direct-current arc fault occurs in the photovoltaic module. It is determined that the direct-current arc fault occurs in the photovoltaic module if the module voltage is less than the voltage anomaly detection threshold. The voltage anomaly detection threshold may be a preset fixed threshold as needs, or may be determined adaptively, which is not limited in this embodiment.

Furthermore, in an embodiment, upon locating the photovoltaic module where the direct-current arc fault occurs, a corresponding measure may be taken, such as outputting an alarm prompt to indicate the photovoltaic module where the direct-current arc fault occurs.

In this embodiment, upon determining that the direct-current arc fault really occurs, the module voltage of the photovoltaic module is acquired from the power optimizer. The photovoltaic module where the direct-current arc fault occurs is located by comparing the module voltage with the voltage anomaly detection threshold, so that the technicians can clearly locate the photovoltaic module where the direct-current arc fault occurs, and perform maintenance and management, improving the troubleshooting efficiency of the direct-current arc fault.

Furthermore, in an embodiment, the step S60 includes the following step S601.

In step S601, a mean value of the module voltages of all the photovoltaic modules is calculated, and the mean value is multiplied by a first preset multiple to obtain the voltage anomaly detection threshold, where the first preset multiple is greater than 0 and less than 1.

In this embodiment, a method for obtaining the voltage anomaly detection threshold is provided. The mean value of the obtained module voltages of various photovoltaic modules is calculated, and the mean value is multiplied by the preset multiple (hereinafter referred to as the first preset multiple for distinction) to obtain the voltage anomaly detection threshold. Where, the first preset multiple is greater than 0 and less than 1, depending on the actual needs. A larger first preset multiple indicates a lower missed detection rate, but false detection may occur. A smaller first preset multiple indicates a lower false detection rate, but missed detection may occur.

It should be noted that the module voltages of various photovoltaic modules are almost the same if no direct-current arc fault occurs. If the direct-current arc fault occurs in one photovoltaic module, the module voltage of the photovoltaic module is less than the mean value of the module voltages of various photovoltaic modules. Therefore, whether the direct-current arc fault occurs in the photovoltaic module can be detected by multiplying the mean value of the module voltages of various photovoltaic modules by the first preset multiple to obtain the voltage anomaly detection threshold, and comparing the module voltage of the photovoltaic module with the voltage anomaly detection threshold.

Furthermore, in an embodiment, the step S60 includes the following step S602.

In step S602, a historical module voltage of the photovoltaic module is obtained from the power optimizer corresponding to the photovoltaic module during a period that no direct-current arc fault occurs in the photovoltaic system, and the historical module voltage is determined as the voltage anomaly detection threshold corresponding to the photovoltaic module.

In this embodiment, another method for obtaining the voltage anomaly detection threshold is provided. The arc detection device may obtain the module voltages (hereinafter referred to as the historical module voltage) of various photovoltaic modules in advance on condition that no direct-current arc fault occurs in the photovoltaic system. For each of the photovoltaic modules, the historical module voltage of the photovoltaic module during a period that no direct-current arc fault occurs in the photovoltaic module is determined as the voltage anomaly detection threshold corresponding to the photovoltaic module.

The step S70 includes the following step S701.

In step S701, it is determined that the direct-current arc fault occurs in the photovoltaic module if the module voltage of the photovoltaic module is less than the voltage anomaly detection threshold corresponding to the photovoltaic module.

The obtained module voltage of the photovoltaic module is compared with the voltage anomaly detection threshold corresponding to the photovoltaic module, and the arc detection device determines that the direct-current arc fault occurs in the photovoltaic module if the module voltage of the photovoltaic module is less than the corresponding voltage anomaly detection threshold. It can be understood that if the direct-current arc fault occurs in the photovoltaic module, the module voltage of the photovoltaic module is less than a voltage of the photovoltaic module where no direct-current arc fault occurs. Therefore, whether the direct-current arc fault occurs in the photovoltaic module can be detected by determining the module voltage of the photovoltaic module during a period that no arc fault occurs as the voltage anomaly detection threshold, and comparing the module voltage of the photovoltaic module with the voltage anomaly detection threshold.

Furthermore, based on the above embodiments, the method for direct-current arc fault detection in a photovoltaic system is provided according to another embodiment of the present disclosure. In this embodiment, the step S40 includes the following step S401.

In step S401, an arc fault determination threshold is obtained, where the arc fault determination threshold is a preset fixed threshold or an adaptive threshold calculated based on second arc signal features in a historical data set.

In this embodiment, the first arc signal feature may be compared with the preset fixed threshold or the adaptive threshold, and it is determined whether the direct-current arc fault occurs based on a comparison result.

In an embodiment, the arc detection device may obtain the arc fault determination threshold. The arc fault determination threshold may be the preset fixed threshold, or may be the adaptive threshold calculated based on arc signal features (hereinafter referred to as the second arc signal features) in the historical data set.

The arc signal features, that is, the second arc signal features, extracted based on the alternating-current signal at the direct-current side throughout a historical time period are stored in the historical data set. In this embodiment, the historical time period throughout which the arc signal feature is stored in the historical data set is not limited, depending on the actual needs. The method in which the arc detection device calculates the arc fault determination threshold based on the second arc signal features is not limited in this embodiment, such as, calculating an average or a weighted average of the second arc signal features, depending on the actual needs. If the second arc signal features include multiple types of feature values, for example, four types of feature values including a mean value, a root mean square value, a variance and a kurtosis, the arc detection device may calculate, based on one type of feature values in the second arc signal features, the arc fault determination threshold corresponding to the type of feature values. Finally, the arc fault determination thresholds corresponding to various types of feature values are obtained.

Furthermore, in an embodiment, it is determined whether the direct-current arc fault occurs by comparing the first arc signal feature with the preset fixed threshold, and fixed thresholds corresponding to different sensitivity values are preset, to meet the sensitivity requirements of different users for arc detection, thereby improving the flexibility of detection. The arc detection device may obtain a currently set sensitivity value of arc fault detection. Where, the arc detection device may be set up with a way for the user to input the sensitivity value of arc fault detection, and the user may set the sensitivity value of arc fault detection as needed. A higher sensitivity value indicates a lower missed detection rate, but false detection may occur. A lower sensitivity value indicates a lower false detection rate, but missed detection may occur. The arc detection device selects, from the fixed thresholds corresponding to various preset sensitivity values, a fixed threshold corresponding to the currently set sensitivity value of arc fault detection as a threshold, that is, the arc fault determination threshold, for comparing with the currently extracted first arc signal feature. In an embodiment, it is determined that a suspected direct-current arc fault occurs if the first arc signal feature is less than the arc fault determination threshold, and a high fixed threshold may be set in a case of a lower sensitivity value.

In step S402, the first arc signal feature is compared with the arc fault determination threshold, and the result of the direct-current arc fault detection in the photovoltaic system is obtained based on a comparison result.

After obtaining the arc fault determination threshold, the arc detection device compares the first arc signal feature with the arc fault determination threshold to obtain the comparison result, and determines whether the suspected direct-current arc fault occurs based on the comparison result. Where, the comparison result reflects the relationship between the first arc signal feature and the arc fault determination threshold. A manner for determining whether a suspected direct-current arc fault occurs based on the comparison result is set as needed, which is not limited in this embodiment. For example, in an embodiment, it is determined that a suspected direct-current arc fault occurs if the first arc signal feature is greater than the arc fault determination threshold. In an embodiment, the first arc signal feature includes multiple types of feature values, and each type of feature values may be compared with the arc fault determination threshold corresponding to the type.

Furthermore, in an embodiment, the step S401 includes the following step S4011.

In step S4011, the preset historical data set is obtained, a mean value of all the second arc signal features in the historical data set is calculated, and the mean value is multiplied by a second preset multiple to obtain the arc fault determination threshold.

In this embodiment, a method for calculating the arc fault determination threshold in a case that the arc fault determination threshold is the adaptive threshold calculated based on the second arc signal features in the historical data set is provided. The arc detection device first calculates the mean value of the second arc signal features in the historical data set, and then multiplies the mean value by a preset multiple (hereinafter referred to as the second preset multiple) to obtain the arc fault determination threshold. Where, it is determined that the suspected direct-current arc fault occurs if the first arc signal feature is less than the arc fault determination threshold, and the second preset multiple is generally set to be greater than 0 and less than 1, avoiding false detection due to the first arc signal feature being less than the arc fault determination threshold under a condition that no direct-current arc fault actually occurs, and only a small fluctuation occurs in the alternating-current signal at the direct-current side.

Furthermore, in an embodiment, after the step S40, the method further includes the following steps S80 and S90.

In step S80, the inverter is shut down to report the arc fault if the result of the direct-current arc fault detection is that the direct-current arc fault occurs in the photovoltaic system.

In this embodiment, a measure for the direct-current arc fault occurring in the photovoltaic system is provided. Upon determining that the direct-current arc fault occurs, the arc detection device shuts down the inverter due to failure, and reports the arc fault by shutting down the inverter. In an embodiment, failure shutdown of the inverter refers to disabling the function of converting direct-current power into alternating-current power, and other functions are continually enabled.

In step S90, the inverter is started if a preset self-starting condition is met and a duration for which the inverter is shut down is a second preset duration, and the step of acquiring the alternating-current signal at the direct-current side of the inverter in the photovoltaic system is performed.

Furthermore, in an embodiment, after the inverter is shut down, the arc detection device may time the duration for which the inverter is shut down if the preset self-starting condition is met, and start the inverter if the preset duration expires. After the inverter is started, the arc detection device continues to the process of acquiring the alternating-current signal at the direct-current side of the inverter in the photovoltaic system and performing the direct-current arc fault detection. Where, the preset self-starting condition may be set as needed. For example, a self-starting function is set by a user, the self-starting function is disabled if the failure shutdown of the inverter occurs N times in one day, while the self-starting function is enabled if the failure shutdown of the inverter occurs less than N times in one day, and N may be set as needed, for example, set to 5.

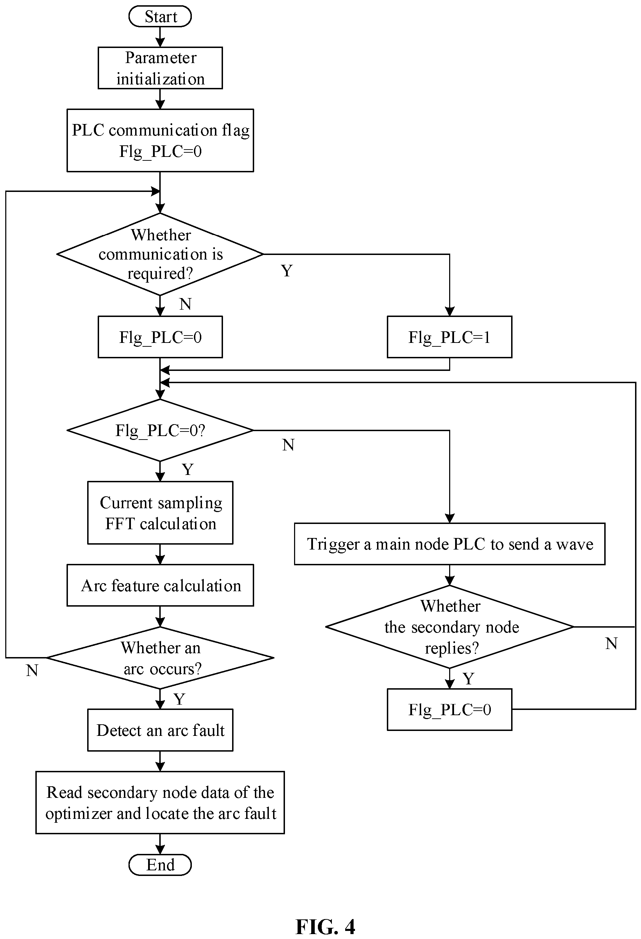

Further, in an embodiment, FIG. 4 illustrates the process of direct-current arc fault detection.

In step 1, parameters are initialized when the inverter is powered on. The arc detection frequency band is preset to [F1, F2], a PLC communication flag is initialized as Flg_PLC=0, and the second preset multiple of the photovoltaic module is preset to K_vf.

In step 2, during grid-connected operation, at the beginning of a single control cycle, the arc detection device determines whether the optimizer control device is in communication with a secondary node optimizer (i.e., the power optimizer). If the optimizer control device is in communication with the power optimizer, the communication flag Flg_PLC is set to 1. If the optimizer control device is not in communication with the power optimizer, the communication flag Flg_PLC is set to 0.

In step 3, a logic processing is performed based on the PLC communication flag. If Flg _PLC=0, the arc detection logic is performed and step 4 is performed; and if Flg_PLC=1, an optimizer control program is executed and step 6 is performed.

In step 4, the arc detection device and the optimizer control device acquires the alternating-current signal at the direct-current side of the inverter in a real time manner, and extract the arc signal feature (represented by arc feature in Figure 4) in the frequency band [F1, F2] through fast Fourier transform (FFT). The arc signal feature includes but is not limited to at least one signal feature such as the mean value, the root mean square value, the variance, or the kurtosis.

In step 5, the arc signal feature is compared with the preset threshold or the adaptive threshold to determine whether an arc fault occurs. If the arc fault occurs, step 7 is performed; and if no arc fault occurs, the step 2 is performed.

In step 6, a main node PLC is triggered to send a wave and performs information interaction with the secondary node optimizer. If a reply from the secondary node ends, the communication flag Flg_PLC is set to 0, otherwise, the step 3 is performed.

In step 7, the inverter is shut down due to failure, to report the arc fault, secondary node data of the optimizer is read, the module voltage of the photovoltaic module is obtained, thus locating the arc fault.

A communication time period is set for the communication of the power optimizer. A timer starts timing, and the communication flag is reset once if the preset communication time period expires. Upon detecting an arc fault, the module voltages of all photovoltaic modules in the photovoltaic string are obtained and the mean value V_ave is calculated. If a module voltage V_x is less than K_vf×V_ave, it is determined that an arc fault occurs in the photovoltaic module and troubleshooting is mainly performed on the photovoltaic module. Where, a voltage anomaly identification parameter K_vf may be set to 0.9. Generally, some cells of the photovoltaic module are damaged caused by the arc fault occurring in the photovoltaic module, the voltage of the module decreases accordingly.

In this embodiment, the inverter is compatible with the arc detection program and the optimizer control program, and the arc detection logic and the optimizer control logic are uniformly scheduled, eliminating the impact of PLC communication of the power optimizer on the arc detection, and achieving the compatibility of the arc detection function and the power optimizer function. Upon detecting an arc fault, voltage anomaly data of the photovoltaic module can be read through the information interaction between the primary node and the secondary node of the optimizer, thereby determining the location of the arc fault and improving the troubleshooting efficiency of fault line.

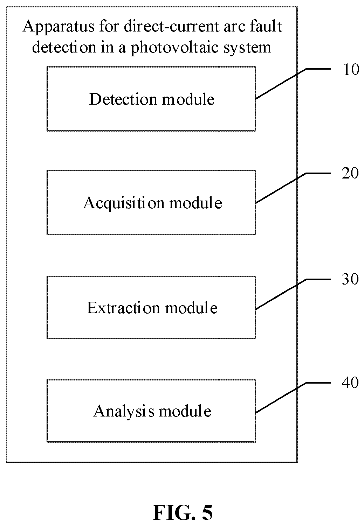

In addition, an apparatus for direct-current arc fault detection in a photovoltaic system is further provided according to an embodiment of the present disclosure. Referring to FIG. 5, the apparatus for direct-current arc fault detection in a photovoltaic system includes a detection module 10, an acquisition module 20, an extraction module 30 and an analysis module 40.

The detection module 10 is configured to detect whether an optimizer control device is in communication with a power optimizer in the photovoltaic system.

The acquisition module 20 is configured to acquire an alternating-current signal at a direct-current side of an inverter in the photovoltaic system, if it is determined that the optimizer control device is not in communication with the power optimizer.

The extraction module 30 is configured to extract a signal feature of the alternating-current signal at the direct-current side in a preset arc detection frequency band as a first arc signal feature.

The analysis module 40 is configured to analyze the first arc signal feature to obtain a result of the direct-current arc fault detection in the photovoltaic system.

Further, the apparatus for direct-current arc fault detection in a photovoltaic system further includes a triggering module.

The triggering module is configured to cyclically trigger a communication between the optimizer control device and the power optimizer at a first preset time interval, where the communication is terminated if an end of information interaction is detected by the optimizer control device or the power optimizer.

Furthermore, a quantity of the power optimizer in the photovoltaic system is more than one, and the power optimizer is configured for power optimization on at least one photovoltaic module in the photovoltaic system.

The acquisition module 20 is further configured to obtain a module voltage of the at least one photovoltaic module from each of the multiple power optimizers, if the result of the direct-current arc fault detection is that the direct-current arc fault occurs in the photovoltaic system; and obtain a voltage anomaly detection threshold.

The analysis module 40 is further configured to determine that the direct-current arc fault occurs in the at least one photovoltaic module, if the module voltage of the at least one photovoltaic module is less than the voltage anomaly detection threshold.

Furthermore, the acquisition module 20 is further configured to calculate a mean value of the module voltages of all the photovoltaic modules, and multiply the mean value by a first preset multiple to obtain the voltage anomaly detection threshold, where the first preset multiple is greater than 0 and less than 1.

Furthermore, the acquisition module 20 is further configured to: determine a historical module voltage of each of the at least one photovoltaic module, obtained from the power optimizer corresponding to the at least one photovoltaic module during a period that no direct-current arc fault occurs in the photovoltaic system, as the voltage anomaly detection threshold corresponding to the photovoltaic module.

The determining that the direct-current arc fault occurs in the at least one photovoltaic module, if the module voltage of the at least one photovoltaic module is less than the voltage anomaly detection threshold includes: determining that the direct-current arc fault occurs in the photovoltaic module, if the module voltage of the photovoltaic module is less than the voltage anomaly detection threshold corresponding to the photovoltaic module.

Furthermore, the extraction module 30 is further configured to convert the alternating-current signal at the direct-current side from a time domain to a frequency domain to obtain a frequency domain signal; and perform feature extraction on signals in the preset arc detection frequency band in the frequency domain signal to obtain the first arc signal feature, where the feature extraction at least includes calculating one or more of a mean value, a root mean square value, a variance and a kurtosis of the signals in the preset arc detection frequency band.

The analysis module 40 is further configured to obtain an arc fault determination threshold, where the arc fault determination threshold is a preset fixed threshold or an adaptive threshold calculated based on second arc signal features in a historical data set; and compare the first arc signal feature with the arc fault determination threshold, and obtain the result of the direct-current arc fault detection in the photovoltaic system based on a comparison result.

Furthermore, the arc fault determination threshold is the adaptive threshold calculated based on the second arc signal features in the historical data set, the acquisition module 20 is further configured to obtain the preset historical data set, calculate a mean value of the second arc signal features in the historical data set, and multiply the mean value by a second preset multiple to obtain the arc fault determination threshold.

Further, the apparatus for direct-current arc fault detection in a photovoltaic system further includes a control module.

The control module is configured to shut down the inverter to report an arc fault, if the result of the direct-current arc fault detection is that the direct-current arc fault occurs in the photovoltaic system; and start the inverter if a preset self-starting condition is met and a duration for which the inverter is shut down is a second preset duration, and go to the process of acquiring an alternating-current signal at a direct-current side of an inverter in the photovoltaic system.

Further details in the embodiments of the apparatus for direct-current arc fault detection in a photovoltaic system in the present disclosure are basically the same as that in above embodiments of the method for direct-current arc fault detection in a photovoltaic system, and thus are not described again here.

In addition, a computer-readable storage medium is provided according to an embodiment of the present disclosure. The storage medium stores a program for direct-current arc fault detection in a photovoltaic system, where the program for direct-current arc fault detection in a photovoltaic system performs, when being executed by a processor, the method for direct-current arc fault detection in a photovoltaic system described above.

For the various embodiments of the device for direct-current arc fault detection in a photovoltaic system and the computer-readable storage medium according to the present disclosure, reference can be made to the various embodiments of the method for direct-current arc fault detection in a photovoltaic system in the present disclosure, which is not described again here.

It should be noted that the terms "including", "comprising" or any other variant thereof used herein are intended to be non-exclusive inclusion. A process, method, article or apparatus including a series of elements includes not only those elements, but also other elements not expressly listed, or elements inherent to the process, method, article or apparatus. Unless expressively limited otherwise, the element defined by the statement "comprising (including) a..." does not exclude the case that other similar elements may exist in the process, method, article or apparatus including the element.

The serial numbers of embodiments of the present disclosure are for descriptive purposes only and does not imply the merit of the embodiments.

From the description of the above embodiments, those skilled in the art may clearly understand that the method in the above embodiments may be implemented by software and a necessary general hardware platform, or implemented by hardware. However, the method is preferably implemented by software and the necessary general hardware platform in most cases. Based on this understanding, the technical solution of the present disclosure essentially, or a part contributing to the conventional technology may be embodied in the form of a software product. The computer software product is stored in a storage medium (for example, a ROM/RAM, a magnetic disk, and an optical disk) and includes various instructions to instruct a terminal device (such as a mobile phone, a computer, a server, an air conditioner, or a network device) to perform the method according to the present disclosure.

Only preferred embodiments of the present disclosure are described herein with no limitation on the scope of protection of the present disclosure. Any equivalent structure or equivalent process transformation made based on the specification and the drawings of the present disclosure, or directly or indirectly used in other related technical fields, is also included in the scope of protection of the present disclosure.

## Claims

1. A method for direct-current arc fault detection in a photovoltaic system, comprising:
detecting whether an optimizer control device is in communication with a power optimizer in the photovoltaic system;
acquiring an alternating-current signal at a direct-current side of an inverter in the photovoltaic system, if it is determined that the optimizer control device is not in communication with the power optimizer;
extracting a signal feature of the alternating-current signal at the direct-current side in a preset arc detection frequency band as a first arc signal feature; and
analyzing the first arc signal feature to obtain a result of the direct-current arc fault detection in the photovoltaic system.

2. The method for direct-current arc fault detection in a photovoltaic system according to claim 1, further comprising:
cyclically triggering a communication between the optimizer control device and the power optimizer at a first preset time interval, wherein the communication is terminated if an end of information interaction is detected by the optimizer control device or the power optimizer.

3. The method for direct-current arc fault detection in a photovoltaic system according to claim 1, wherein a quantity of the power optimizer in the photovoltaic system is more than one, and the power optimizer is configured for power optimization on at least one photovoltaic module in the photovoltaic system, wherein
after the analyzing the first arc signal feature to obtain a result of the direct-current arc fault detection in the photovoltaic system, the method further comprises:
obtaining a module voltage of the at least one photovoltaic module from each of the plurality of power optimizers, if the result of the direct-current arc fault detection is that a direct-current arc fault occurs in the photovoltaic system;
obtaining a voltage anomaly detection threshold; and
determining that the direct-current arc fault occurs in the at least one photovoltaic module if the module voltage of the at least one photovoltaic module is less than the voltage anomaly detection threshold.

4. The method for direct-current arc fault detection in a photovoltaic system according to claim 3, wherein the obtaining a voltage anomaly detection threshold comprises:
calculating a mean value of the module voltages of all the photovoltaic modules, and multiplying the mean value by a first preset multiple to obtain the voltage anomaly detection threshold, wherein the first preset multiple is greater than 0 and less than 1.

5. The method for direct-current arc fault detection in a photovoltaic system according to claim 3, wherein the obtaining a voltage anomaly detection threshold comprises:
determining a historical module voltage of each of the at least one photovoltaic module, obtained from the power optimizer corresponding to the at least one photovoltaic module during a period that no direct-current arc fault occurs in the photovoltaic system, as the voltage anomaly detection threshold corresponding to the photovoltaic module, wherein
the determining that the direct-current arc fault occurs in the at least one photovoltaic module if the module voltage of the at least one photovoltaic module is less than the voltage anomaly detection threshold comprises:
determining that the direct-current arc fault occurs in the photovoltaic module if the module voltage of the photovoltaic module is less than the voltage anomaly detection threshold corresponding to the photovoltaic module.

6. The method for direct-current arc fault detection in a photovoltaic system according to claim 1, wherein the extracting a signal feature of the alternating-current signal at the direct-current side in a preset arc detection frequency band as a first arc signal feature comprises:
converting the alternating-current signal at the direct-current side from a time domain to a frequency domain to obtain a frequency domain signal; and
performing feature extraction on signals in the preset arc detection frequency band in the frequency domain signal to obtain the first arc signal feature, wherein the feature extraction at least comprises calculating one or more of a mean value, a root mean square value, a variance and a kurtosis of the signals in the preset arc detection frequency band.

7. The method for direct-current arc fault detection in a photovoltaic system according to claim 1, wherein the analyzing the first arc signal feature to obtain a result of the direct-current arc fault detection in the photovoltaic system comprises:
obtaining an arc fault determination threshold, wherein the arc fault determination threshold is a preset fixed threshold or an adaptive threshold calculated based on second arc signal features in a historical data set; and
comparing the first arc signal feature with the arc fault determination threshold, and obtaining the result of the direct-current arc fault detection in the photovoltaic system based on a comparison result.

8. The method for direct-current arc fault detection in a photovoltaic system according to claim 7, wherein the arc fault determination threshold is the adaptive threshold calculated based on the second arc signal features in the historical data set, and the obtaining the arc fault determination threshold comprises:
obtaining the preset historical data set, calculating a mean value of the second arc signal features in the historical data set, and multiplying the mean value by a second preset multiple to obtain the arc fault determination threshold.

9. The method for direct-current arc fault detection in a photovoltaic system according to any one of claims 1 to 8, wherein after the analyzing the first arc signal feature to obtain a result of the direct-current arc fault detection in the photovoltaic system, the method further comprises:
shutting down the inverter to report an arc fault if the result of the direct-current arc fault detection is that the direct-current arc fault occurs in the photovoltaic system;
starting the inverter if a preset self-starting condition is met and a duration for which the inverter is shut down is a second preset duration; and
going to the process of acquiring an alternating-current signal at a direct-current side of an inverter in the photovoltaic system.

10. An apparatus for direct-current arc fault detection in a photovoltaic system, comprising:
a detection module, configured to detect whether an optimizer control device is in communication with a power optimizer in the photovoltaic system;
an acquisition module, configured to acquire an alternating-current signal at a direct-current side of an inverter in the photovoltaic system, if it is determined that the optimizer control device is not in communication with the power optimizer;
an extraction module, configured to extract a signal feature of the alternating-current signal at the direct-current side in a preset arc detection frequency band as a first arc signal feature; and
an analysis module, configured to analyze the first arc signal feature to obtain a result of the direct-current arc fault detection in the photovoltaic system.

11. A device for direct-current arc fault detection in a photovoltaic system, comprising:
a memory;
a processor; and
a program for direct-current arc fault detection in a photovoltaic system, stored in the memory and executable by the processor, wherein the program for direct-current arc fault detection in a photovoltaic system performs, when being executed by the processor, the method for direct-current arc fault detection in a photovoltaic system according to any one of the claims 1 to 9.

12. A computer-readable storage medium, storing a program for direct-current arc fault detection in a photovoltaic system, wherein the program for direct-current arc fault detection in a photovoltaic system performs, when being executed by a processor, the method for direct-current arc fault detection in a photovoltaic system according to any one of the claims 1 to 9.
